Europäisches Patentamt

European Patent Office

Office européen des brevets

(19)

(11)  EP 0 598 277 B1

(12)  **EUROPÄISCHE PATENTSCHRIFT**

(45) Veröffentlichungstag und Bekanntmachung des Hinweises auf die Patenterteilung:
**15.10.1997  Patentblatt 1997/42**

(51) Int Cl.⁶: **H03D 3/00**

(21) Anmeldenummer: **93117761.2**

(22) Anmeldetag: **03.11.1993**

(54) **Verfahren und Vorrichtung zur Korrektur von DC-Anteilen bei direktmischenden Empfangseinrichtungen**

Method and device for the correction of DC-levels in direct conversion receivers

Méthode et appareil pour la correction de niveaux de courant continu dans des récepteurs à conversion directe

(84) Benannte Vertragsstaaten:
**AT BE CH DE DK ES FR GB GR IE IT LI LU MC NL PT SE**

(30) Priorität: **14.11.1992  DE 4238542**

(43) Veröffentlichungstag der Anmeldung:
**25.05.1994  Patentblatt 1994/21**

(73) Patentinhaber: **Hagenuk Telecom GmbH 24118 Kiel (DE)**

(72) Erfinder:
- **Kluge, Wolfram**
  **D-01309 Dresden (DE)**
- **Jehring, Frieder**
  **D-01189 Dresden (DE)**
- **Krause, Frank-Michael**
  **D-01069 Dresden (DE)**

(74) Vertreter: **Hansmann, Dierk, Dipl.-Ing. et al Patentanwälte Hansmann-Klickow-Hansmann Jessenstrasse 4 22767 Hamburg (DE)**

(56) Entgegenhaltungen:
**EP-A- 0 343 273          EP-A- 0 496 621 DE-A- 3 938 643**

## Beschreibung

Die Erfindung betrifft ein Verfahren und eine Vorrichtung zur Korrektur von DC-Anteilen in Empfangssignalen bei direktmischenden Empfangssystemen.

Bei Direct-Conversion-Empfängern, die gelegentlich auch als Homodynempfänger oder Null-ZF-Empfänger bezeichnet werden, wird das empfangene, winkelmodulierte Hochfrequenzsignal (HF-Signal) mit dem Signal eines lokalen Oszillators (LO) gemischt, dessen Frequenz näherungsweise der Trägerfrequenz des HF-Signals entspricht. Da das LO-Signal ungefähr die gleiche Frequenz aufweist wie das HF-Signal, entsteht nach der Mischung ein Zwischenfrequenzsignal (ZF-Signal), das im niederfrequenten Bereich (NF-Bereich) liegt. Mathematisch gesehen entstehen bei der Mischung zeitweise negative Frequenzen, die aber in der Praxis nicht von den positiven Frequenzen unterschieden werden können. Zur Aufrechterhaltung der vollen Information ist es bei Direct-Conversion-Empfängern notwendig, zwei um 90° zueinander verschobene ZF-Signale zu bilden. Dazu sind zwei Mischer vorhanden, an die das HF-Signal und das LO-Signal angelegt werden, wobei das an die eine Mischstufe angelegte HF- oder LO-Signal gegenüber dem entsprechenden, an die andere Mischstufe angelegten, Signal um 90° phasenverschoben ist. Die eine Mischstufe, vor der keine Phasenverschiebung folgt, erzeugt ein erstes ZF-Signal, das als in-phase-Signal (I) bezeichnet wird. An dem zweiten Mischer wird ein zweites ZF-Signal erzeugt, das zum ersten ZF-Signal um 90° phasenverschoben ist und das als Quadratursignal (Q) bezeichnet wird. Die beiden ZF-Signale (I), (Q), werden über jeweils ein Tiefpaßfilter zur Selektion eines Empfangskanals und einen ZF-Verstärker geführt. Die verstärkten und gefilterten Signale können einem Demodulator zugeführt werden. Da die ZF-Signale im NF-Bereich liegen, werden an den ZF-Verstärker keine hohen Anforderungen gestellt und es besteht die Möglichkeit, ZF-Filter sowie Demodulator nach Analog-Digital-Wandlung der ZF-Signale in einem Rechenwerk digital zu realisieren. Hierzu bieten sich digitale Signalprozessoren als kostengünstige Lösung an. Insbesondere ist die Verwendung von Festkommarechnern angestrebt. Gegenüber herkömmlichen Super-Heterodynempfängern haben Direct-Conversion-Empfänger den Vorteil, daß das Problem der Spiegelfrequenzunterdrückung nicht auftritt und daher keine schmalbandigen HF-Filter für die Vorselektion vor dem Mischer und für die ZF-Signale benötigt werden. Direct-Conversion-Empfänger sind deshalb für eine vollständig integrierte Lösung geeignet.

Trotz dieser Vorteile ist bis heute das Konzept des Direct-Conversion-Empfängers in keinem nennenswerten Umfang eingesetzt worden. Ein Grund dafür ist, daß Signale mit der Frequenz 0 (Gleichanteile) mit zum ZF-Spektrum gehören. Daher stellt jeder Gleichspannungsoffset in den ZF-Kanälen eine Störfrequenz im Empfangsband dar, deren Auswirkungen sich prinzipiell nicht beseitigen sondern nur verringern lassen. Gleichsspannungsoffsets entstehen aber nahezu unvermeidlich in den Mischern durch Übersprechen der HF-Signale an den Mischereingängen, bei großen Empfangssignalen durch Multiplikation mit sich selbst an der nichtlinearen Mischereingangskennlinie und durch Bauelementetoleranzen als statische Größen im Mischer sowie im ZF-Verstärker. Die Gleichsspannungsoffsets können unter Umständen wesentlich größer sein als das DC-Nutzsignal. Der DC-offset wird üblicherweise mittels eines Hochpasses (AC-Kopplung) abgetrennt. Hierbei geht jedoch auch das DC-Nutzsignal verloren, was zu einer Erhöhung des Klirrfaktors führt.

Eine technische Lösung für die bei Direct-Conversion-Empfängern entstehenden Fehler ist es, das Auftreten solcher Fehler möglichst zu vermeiden, indem besonders sorgfältig ausgewählte Bauelemente eingesetzt werden. Dies ist aber mit erheblichem Aufwand verbunden.

Andererseits könnte ein technischer Lösungsansatz darin bestehen, die Fehler nicht zu groß werden zu lassen und zum Beispiel in einem Regelwerk auszugleichen.

In DE 39 38 643 A1 wird ein Verfahren beschrieben, mit dem durch eine langsame Regelung die DC-Offsets ausgeglichen werden. Hierfür wird eine Mittelwertbildung über zahlreiche Zeigerumläufe des durch die I- und Q-Signale beschriebenen Vektors verwendet. Dies bedingt eine lange Regelung. Schnelle, insbesondere auch sprunghafte Änderungen der DC-Offsets werden nicht genügend schnell erkannt.

Aufgabe der Erfindung war es daher, ein Verfahren und eine Vorrichtung zur Korrektur von DC-Anteilen in empfangenen Signalen bei direktmischenden Empfangssystemen anzugeben, die eine schnelle Kompensation der DC-Anteile unter Verwendung möglichst einfacher Prozessoren, insbesondere möglichst einfacher digitaler Signalprozessoren, erlaubt.

Die Lösung dieser Aufgabe erfolgt durch ein Verfahren nach dem kennzeichnenden Teil des Patentanspruchs 1 beziehungsweise durch eine Vorrichtung nach dem kennzeichnenden Teil des Patentanspruchs 3.

Fehlerfreie I- und Q-Signale bilden bei der Darstellung im kartesischen Koordinatensystem einen Kreis in Mittelpunktslage. Der Amplitudenfehler bewirkt ein Strecken oder Stauchen des Kreises in Achsenrichtung. Ein Phasenfehler bewirkt, daß der Kreis bezüglich einer 45°-Geraden gestaucht beziehungsweise gestreckt wird. In beiden Fällen wird der Kreis zur Ellipse verformt. Eine Verlagerung der Ellipse aus dem Ursprung wird durch Gleichspannungsoffsets hervorgerufen. Bei dem erfindungsgemäßen Verfahren wird davon ausgegangen, daß eine Korrektur von Amplituden- und Phasenfehlern unabhängig von Gleichsspannungsoffsets bereits erfolgt ist.

Es zeigen:

Fig. 1 ein Blockschaltbild eines Direct-Conversion-Empfängers;
Fig. 2 eine schematische Darstellung der Kompensation von DC-Offsets;
Fig. 3 ein Ausführungsbeispiel für das erfindungsgemäße Verfahren und die Vorrichtung.

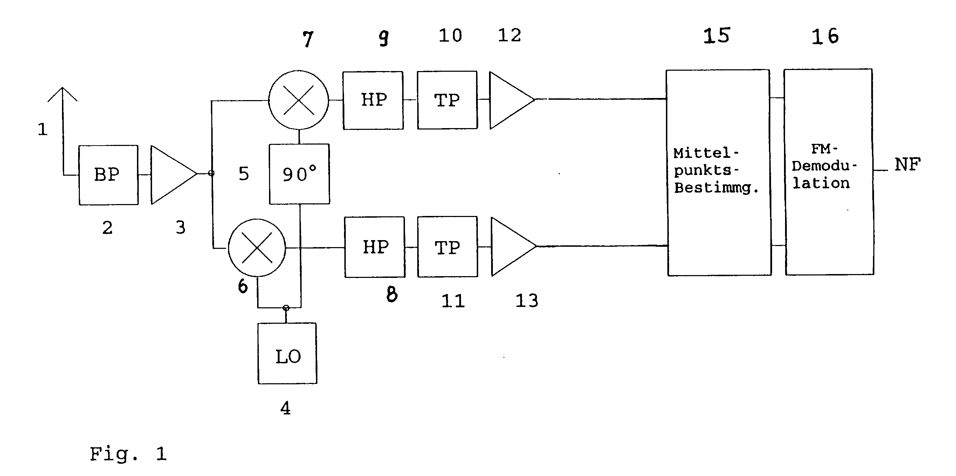

Fig. 1 zeigt die Verwendung des erfindungsgemäßen Verfahrens beziehungsweise der Vorrichtung in einem Direct-Conversion-Empfänger. Das von der Antenne 1 empfangene HF-Signal durchläuft ein Eingangsfilter 2 und wird vom Vorverstärker 3 verstärkt. Durch das Mischerpaar 6, 7 wird das HF-Signal direkt in das Basisband umgesetzt. Die Mischer 6, 7 werden von einem Signal des lokalen Oszillators 4 (LO-Signal) angesteuert, wobei in diesem Ausführungsbeispiel der Mischer 7 ein um 90° phasenverschobenes LO-Signal erhält. Die Frequenz des LO-Signals entspricht näherungsweise der Trägerfrequenz des zu empfangenden FM-Signals. An den Ausgängen der Mischer 6 und 7 liegen die niederfrequenten Basisbandsignale an. Die Spektren dieser Signale entsprechen dem in den niederfrequenten Bereich um die Trägerfrequenz verschobenen FM-Spektrum. Das Signal vom Mischer 6 wird als I-Signal und das dazu um 90° phasenverschobene Signal von Mischer 7 als Q-Signal bezeichnet. Die I- und Q-Signale werden weiter über Hochpässe 8, 9 zum Abtrennen von Gleichspannungsoffsets geleitet. Die folgenden Tiefpässe 10, 11 bilden das Kanalfilter des Empfängers zur Selektions eines Übertragungskanals aus dem Empfangsspektrum. In den Verstärkern 12, 13 wird der Pegel der I- und Q-Signale auf einen für die weitere Verarbeitung nötigen Wert angehoben. Das erfindungsgemäße Korrekturverfahren und die Vorrichtung sind im Mittel 15 realisiert. Letzteres liefert an seinen Ausgängen die Signale IK und QK, in denen DC-Offsets kompensiert sind. Mit diesen Signalen kann unmittelbar die Demodulation erfolgen.

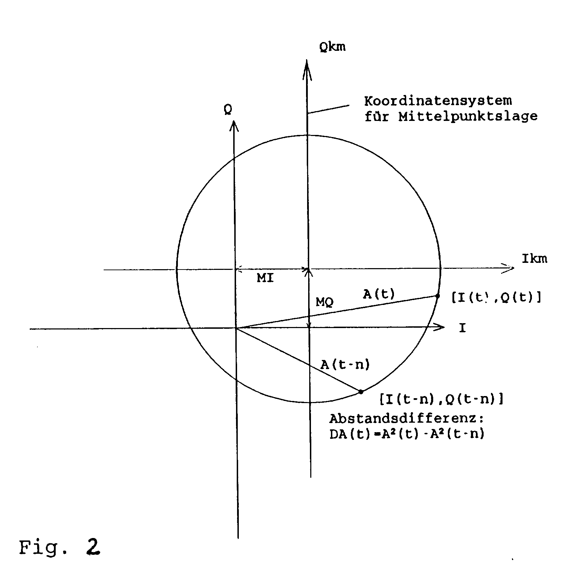

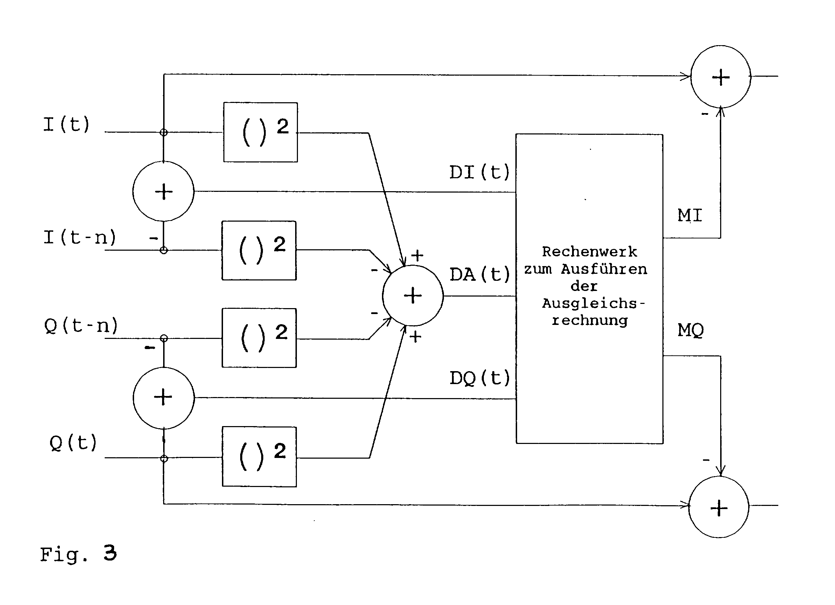

Die Arbeitsweise des Korrekturgliedes 15 wird anhand von Fig. 2 und 3 im Rahmen eines Ausführungsbeispieles beschrieben.

In dem erfindungsgemäßen Verfahren wird im Mittel 15 in Fig. 1 erreicht, daß sich der von den gegebenenfalls korrigierten ZF-Signalen (I, Q) gebildete Kreis immer in Mittelpunktslage befindet. Dazu muß der Mittelpunkt des Kreises (MI, MQ) bestimmt und dieser Wert von den ZF-Signalen (I, Q) subtrahiert werden. Die auf diese Weise korrigierten ZF-Signale werden zur verzerrungsfreien Demodulation dem Demodulator 16 zugeführt.

Fig. 3 zeigt das Verfahren zur Mittelpunktskorrektur. Es wird davon ausgegangen, daß mit abgetasteten Proben der I- und Q-Signale gearbeitet wird. Die zum Zeitpunkt t und zum n Takte früheren Zeitpunkt t-n vorliegenden Abtastwerte der I- und Q-Signale werden jeweils in einer Multiplizierstufe zum Bilden der Quadrate mit sich selbst multipliziert. Die quadrierten Signale zum Zeitpunkt t gehen mit positiven und die quadrierten Signale zum Zeitpunkt t-n mit negativen Vorzeichen an einen Addierer, der das Signal DA(t) liefert. Weiterhin wird die Differenz vom I- bzw. Q-Signal zum jeweils n Takte zurückliegenden Zeitpunkt gebildet, so daß die Signale DI(t) und DQ(t) entstehen. In einem nachfolgenden Rechenwerk wird aus den Abtastwerten der drei Signale DA(t), DI(t) und DQ(t) anhand der Gleichung (1)

$$\frac{DA(t)}{2} + MI(t) * DI(t) + MQ(t) * DQ(t) = W \tag{1}$$

eine Ausgleichsrechnung unter Zuhilfenahme von N Zeitpunkten der Signalvergangenheit durchgeführt, mit dem Ziel, die Fehlergröße W zu minimieren. Die so gewonnenen Mittelpunktskoordinaten MI(t) und MQ(t) werden in Subtrahierstufen von den I- bzw. Q-Signalen subtrahiert.

Zur Beschreibung dieses Verfahrens dient Fig. 2. Die vollständige Beschreibung eines Kreises ist durch drei Größen gegeben: der Radius R und die Mittelpunktkoordinaten MI und MQ. Eine Ausgleichsrechnung am Kreis würde zu einem Gleichungssystem mit 3 Unbekannten führen, dessen Lösung einen erheblichen Rechenaufwand erfordert. Da der Radius R jedoch zur Demodulation des winkelmodulierten Signals nicht benötigt wird, ist es nicht erforderlich, alle Größen in einem Gleichungssystem zu ermitteln. Für eine Menge von N Punkten auf einem Kreis sind die Abstandsdifferenzen nur dann ein Minimum, wenn sie zum Mittelpunkt bezogen sind. In Gleichung (3) werden zur Vereinfachung die Quadrate der Radiusdifferenzen zweier um n Abtastperioden auseinanderliegender Kreispunkte in Abhängigkeit vom Mittelpunkt (MI, MQ) erfaßt und die Fehlergröße W gebildet (wobei im allgemeinen n = 1 ist). Dies erhält man durch den Ansatz

$$R^2(t) - R^2(t-n) = DR^2 \tag{3}$$

$$(I(t) - MI)^2 + (Q(t) - MQ)^2 - (I(t-n) - MI)^2$$

$$- (Q(t-n) - MQ)^2 = DR^2 \tag{5}$$

Durch Ausmultiplizieren erhält man

$$I^2(t) + Q^2(t) - I^2(t-n) - Q^2(t-n) +$$

$$+ 2 * MI * (I(t) - I(t-n)) + 2 * MQ * (Q(t) - Q(t-n)) = DR^2 \qquad (6)$$

Durch Substitution von

$$DA = I^2(t) + Q^2(t) - I^2(t-n) - Q^2(t-n) \qquad (7)$$

und

$$DI = I(t) - I(t-n) \quad bzw. \quad DQ = Q(t) - Q(t-n) \qquad (8)$$

erhält man Gleichung (1)

$$\frac{DA}{2} + MI * DI + MQ * DQ = \frac{DR^2}{2} = W \qquad (9)$$

Die Minimierungsaufgabe besteht darin, die Summe der Quadrate von N Fehlergrößen W, die aus N+1 aufeinanderfolgenden Abtastwerten der Signale I und Q gewonnen wurden, durch eine Ausgleichsrechnung nach I.O. Kerner, Numerische Mathematik mit Kleinstrechnern, Berlin 1985 (quasilineare Regression) zu minimieren. Für jede Unbekannte (Mittelpunktskoordinate) wird eine partielle Ableitung der Funktion W(Gl. 9) vorgenommen.

$$\frac{\partial W^2}{\partial M_i} = \sum_{k=1}^{N} W_k * \frac{\partial W_k}{\partial M_i} \qquad mit \ M_i \ ... \ MI, \ MQ \quad (10)$$

Nach Nullsetzen der beiden Ableitungen erhält man das Gleichungssystem

$$\begin{bmatrix} \sum_{k=1}^{N} DI^2 & \sum_{k=1}^{N} DI * DQ \\ \sum_{k=1}^{N} DI * DQ & \sum_{k=1}^{N} DQ^2 \end{bmatrix} * \begin{bmatrix} MI \\ MQ \end{bmatrix} = \begin{bmatrix} \sum_{k=1}^{N} DA^2 * DI \\ \sum_{k=1}^{N} DA^2 * DQ \end{bmatrix} \qquad (11)$$

dessen Lösung die gesuchten Mittelpunktskoordinaten sind.

Die nach Fig. 3 bestimmten, korrigierten Signale IK und QK können unmittelbar in dem FM-Demodulator 16 (Fig. 1) demoduliert werden.

Die Demodulation kann vorteilhafterweise bei Verwendung eines digitalen Signalprozessors zusammen mit den anderen Korrekturschritten ausgeführt werden.

Mit dem erfindungsgemäßen Verfahren und der Vorrichtung können die Korrekturen des DC-Offsets äußerst schnell durchgeführt werden. Es können auch große Fehler ausgeglichen werden, so daß weder an die Bauteile der HF-Eingangsstufe noch der Mischer und NF-Stufe besondere Anforderungen zu stellen sind. Hierdurch wird erstmals die Möglichkeit eröffnet, direktmischende Empfangssysteme in größerem Umfang einzusetzen.

**Patentansprüche**

1. Verfahren zur Korrektur von Gleichspannungs-Fehlersignalen in Empfangssignalen bei direktmischenden Empfangsvorrichtungen in dem ein winkelmoduliertes, empfangenes hochfrequentes Signal in zwei Mischern mit um 90° phasenverschobenen Oszillator-Signalen mit näherungsweise gleicher Frequenz zu zwei in etwa in Quadratur stehenden niederfrequenten ZF-Signalen I und Q gemischt werden, dadurch gekennzeichnet, daß die Mittelpunktskoordinaten (MI, MQ) der in Quadratur stehenden niederfrequenten ZF-Signale I und Q mit Hilfe einer Ausgleichsrechnung so bestimmt werden, daß eine Anzahl von Differenzen der quadratischen Radien jeweils zweier, zeitlich aufeinander folgender Punkte (I(t), Q(t), I(t-n), Q(t-n)) minimiert werden und von den aktuellen Signalen I und Q subtrahiert werden.

2. Verfahren nach Anspruch 1, dadurch gekennzeichnet, daß

   a) die Signale I und Q periodisch abgetastet werden,
   b) von den abgetasteten Signalen I und Q und von den um n Abtastintervalle zurückliegenden Abtastwerten durch Multiplikation mit sich selbst die Quadrate gebildet werden.
   c) die Summe der quadrierten Signale I und Q gebildet werden und davon die um n Abtastintervalle zurückliegenden quadrierten Signale I und Q subtrahiert werden, um das Signal DA(t) zu bilden,
   d) die Differenzen zwischen dem Abtastwert der Signale I und Q und dem jeweiligen um n Abtastintervalle zurückliegendem Abtastwert zu den Signalen DI(t) und DQ(t) gebildet werden,
   e) aus den in den Verfahrensschritten b), c) und d) erzeugten Signalen DI(t), DQ(t) und DA(t) mittels der Ausgleichsrechnung die Signale MI(t) und MQ(t) in einem Rechenwerk bestimmt werden,
   f) in Subtraktionsstufen die Signale MI(t) und MQ(t) jeweils von den Signalen I bzw. Q abgezogen werden, so daß die korrigierten Signale (Ikm, Qkm) entstehen.

3. Vorrichtung zur Korrektur von DC-Anteilen in Empfangssignalen direktmischender Empfangseinrichtungen, ein winkelmoduliertes, empfangenes hochfrequentes Signal in zwei Mischern mit um 90 ° phasenverschobenen Oszillator-Signalen mit näherungsweise gleicher Frequenz zu zwei etwa in Quadratur stehenden niederfrequenten ZF-Signalen I und Q gemischt werden, dadurch gekennzeichnet, daß ein Korrekturglied (15) angeordnet ist, das zur Bestimmung der Mittelpunktskoordinaten (MI, MQ) der in Quadratur stehenden niederfrequenten ZF-Signale I und Q mit Hilfe einer Ausgleichsrechnung ausgebildet ist und Mittel zur Subtraktion der Mittelpunktskoordinaten von den aktuellen I- und Q-Signalen aufweist, wobei das Korrekturglied (15) zur Bestimmung einer Anzahl von Differenzen der quadratischen Radien jeweils zweier zeitlich aufeinander folgender Punkte und zur Minimierung der Differenzen ausgebildet ist.

4. Vorrichtung nach Anspruch 3, dadurch gekennzeichnet, daß das Korrekturglied (15)

   a) zur periodischen Abtastung der I- und Q-Signale,
   b) zur Bildung von Quadraten der abgetasteten I- und Q-Werte und der um n Abtastintervalle zurückliegenden Abtastwerte,
   c) zur Summierung der quadratischen Werte und zur Subtraktion von um n Abtastintervalle zurückliegenden quadratischen Werten,
   d) zur Subtraktion der I- und Q-Werte von den entsprechenden um n Abtastintervalle zurückliegenden Werten,
   e) zur Berechnung der Mittelpunktskoordinaten aus den in den Schritten b), c) und d) erzeugten Werten durch Minimierung der Differenzen mittels der Ausgleichsrechnung und
   f) zur Subtraktion der Mittelpunktskoordinaten von den I- und Q-Werten

   ausgebildet ist.

**Claims**

1. Process for correcting DC voltage error signals in received signals in direct-conversion receiving devices, in which an angle-modulated, received high-frequency signal is mixed in two mixers with oscillator signals of approximately identical frequency and phase-shifted by 90°, into two low-frequency IF signals I and Q approximately in quadrature, **characterised in that** the mid-point coordinates (MI, MQ) of the quadrature low-frequency IF signals I and Q are specified with the aid of a correction calculation so that a number of differences of the quadratic radii of each of two points in chronological order (I(t), Q(t), I(t-n), Q(t-n)) are minimised and subtracted from the current signals I and Q.

2. Process according to Claim 1, **characterised in that**

    a) the signals I and Q are periodically sampled,
    b) the squares are formed from the sampled signals I and Q and from the sampled values which occurred n sampling intervals before, by mutual multiplication.
    c) the sums of the squared signals I and Q are established and the squared signals I and Q which occurred n sampling intervals before, are subtracted from them in order to generate the signal DA(t),
    d) the differences between the sampled value of the signals I and Q and the respective sampled value which occurred n sampling intervals before, form the signals DI(t) and DQ(t),
    e) the signals MI(t) and MQ(t) are determined in an arithmetic unit from the signals DI(t), DQ(t) and DA(t) generated in process steps b), c) and d) by means of the correction calculation,
    f) each of the signals MI(t) and MQ(t) is subtracted in subtraction stages from the signals I and Q, respectively, thus producing the corrected signals (Ikm, Qkm).

3. Device for correcting DC components in received signals of direct-conversion receiving devices in which an angle-modulated, received high-frequency signal is mixed in two mixers with oscillator signals of approximately identical frequency and phase-shifted by 90°, into two low-frequency IF signals I and Q approximately in quadrature, **characterised in that** a correction device (15) is arranged, which is configured to determine the mid-point coordinates (MI, MQ) of the quadrature low-frequency IF signals I and Q, with the aid of a correction calculation, and which device has means for subtracting the mid-point coordinates from the current I and Q signals, the correction device (15) being configured to determine a number of differences of the quadratic radii of each of two points in chronological order and to minimise the differences.

4. Device according to Claim 3, **characterised in that** the correction device (15) is configured

    a) for the periodic sampling of the I and Q signals,
    b) for the generation of squares of the sampled I and Q values and the sampled values which occurred n sampling intervals before,
    c) for the summing of the quadratic values and for the subtraction of quadratic values which occurred n sampling intervals before,
    d) for the subtraction of the I and Q values from the corresponding values which occurred n sampling intervals before,
    e) for the calculation of the mid-point coordinates from the values generated in steps b), c) and d) by minimising the differences, by means of the correction calculation, and
    f) for the subtraction of the mid-point coordinates of the I and Q values.

**Revendications**

1. Procédé de correction de niveaux de courant continu dans les signaux de réception des appareils de réception à conversion directe dans lesquels un signal haute fréquence modulé en phase capté est mélangé dans deux étages de conversion à des signaux d'oscillateur en quadrature et de fréquence approximativement égale pour obtenir deux signaux basse-fréquence intermédiaires I et Q en quadrature, caractérisés par le fait que, les coordonnées de l'origine (MI, MQ) des signaux basse-fréquence intermédiaires I et Q, en quadrature, sont déterminées par un calcul de compensation de telle façon qu'un nombre de différences des rayons en quadrature de chaque paire de points (I(t), Q(t), I(t-n), Q(t-n)) est minimisé et soustrait des signaux I et Q présents.

2. Procédé selon la revendication 1, caractérisé par le fait que :

    a) les signaux I et Q sont échantillonnés périodiquement,
    b) les carrés des signaux I et Q et des valeurs d'échantillonnage antérieure de n intervalles d'échantillonnage sont obtenus par multiplication par eux-mêmes.
    c) la somme des carrés des signaux I et Q diminuée des carrés des signaux I et Q antérieure de n intervalles d'échantillonnage est obtenue pour former le signal DA(t),
    d) les différences entre la valeur d'échantillonnage des signaux I et Q et de chaque valeur d'échantillonnage correspondante antérieure de n intervalles d'échantillonnage par rapport aux signaux DI(t) et DQ(t) sont obtenues,

e) les signaux MI(t) et MQ(t) sont obtenus par le calcul de compensation partant des signaux DI(t), DQ(t) et DA(t) obtenus dans les étapes b), c) et d),

f) les signaux MI(t) et MQ(t) sont soustraits des signaux correspondants I et Q, pour obtenir les signaux corrigés (Ikm, Qkm).

3. Dispositif de correction des composantes de courant continu dans les signaux de réception d'appareils de réception à conversion directe, un signal haute-fréquence modulé en phase capté étant converti en deux signaux basse-fréquence intermédiaires I et Q par mélange dans deux étages de conversion avec deux signaux d'oscillateurs en quadrature et de fréquence approximativement égale, caractérisé par la présence d'un circuit de correction (15) conçu pour déterminer les coordonnées de l'origine (MI, MQ) des signaux basse-fréquence intermédiaires en quadrature I et Q à l'aide d'un calcul de compensation et qui comporte des moyens de soustraction des coordonnées de l'origine des signaux I et Q courants dans lesquelles le circuit de correction (15) détermine une quantité de différences des carrés des rayons de chaque paire de points successifs dans le temps et conçu pour minimiser les différences.

4. Dispositif selon la revendication 3, caractérisé par la fait que le circuit de correction (15) est conçu pour :

a) l'échantillonnage périodique des signaux I et Q,

b) générer les carrés des valeurs échantillonnées de I et Q et des valeurs d'échantillonnage antérieures de n intervalles d'échantillonnage,

c) la sommation des carrés et de la soustraction des carrés des valeurs échantillonnées antérieures de n intervalles d'échantillonnage,

d) la soustraction des valeurs I et Q des valeurs correspondantes antérieures de n intervalles d'échantillonnage,

e) le calcul des coordonnées de l'origine obtenues par réduction au minimum des différences des valeurs obtenues dans les étapes b), c) et d) par le calcul de compensation et

f) la soustraction des coordonnées de l'origine des valeurs I et Q.

Fig. 1

Fig. 2

Rechenwerk
zum Ausführen
der
Ausgleichsrechnung

MI

MQ

DI(t)

DA(t)

DQ(t)

( )²

( )²

( )²

( )²

I(t)

I(t-n)

Q(t-n)

Q(t)

Fig. 3